# EUROPEAN PATENT APPLICATION

(11) **EP 1 605 598 A1**
(43) Date of publication of application: **14.12.2005**
(21) Application number: 04723000.8
(22) Date of filing: 24.03.2004
(51) Int. Cl.: H03M 13/47, H03M 13/29, H04L 1/00

(54) **RADIO TRANSMISSION APPARATUS, RADIO RECEPTION APPARATUS AND RADIO TRANSMISSION METHOD**

(30) Priority: 28.03.2003 JP 2003091749
(71) Applicant: MATSUSHITA ELECTRIC INDUSTRIAL CO., LTD., Kadoma-shi, Osaka 571-8501 (JP)
(72) Inventor: YOSHII, Isamu, Chiba 279-0014 (JP)
(74) Representative: Grünecker, Kinkeldey, Stockmair & Schwanhäusser Anwaltssozietät
(86) International application number: PCT/JP2004/004036
(87) International publication number: WO 2004/088853

(57) **Abstract**

Transmission data in a different interleaving pattern is input for each retransmission via interleaver 31 to outer coding processing section 32 that performs coding processing with a strong correction capability for the burst error such as Reed-Solomon coding. Inner coding processing section 33 performs coding processing with a strong correction capability for the random error such as turbo coding. Different outer code parity bits are thus transmitted for each retransmission, and the decoding side is capable of performing outer code decoding processing using different outer code parity bits corresponding to the number of retransmissions, and thus improves the correction capability for the burst error. As a result, it is possible to acquire both the combining gain due to the inner coding processing and the diversity effect due to the outer code by retransmission, and it is thus possible to effectively reduce both the random error and burst error while taking full advantage of retransmission.

## Description

### Technical Field

The present invention relates to a radio transmission apparatus, radio reception apparatus and radio transmission method that improve communication quality using retransmission techniques such as, for example, an H-ARQ scheme.

### Background Art

In recent years, in the field of wireless communications, downlink high-speed packet transmission systems have been developed where a plurality of mobile station apparatuses share a high-speed large-capacity downlink channel, and a base station apparatus transmits packets to the mobile station apparatus. As one of the techniques to implement the high-speed packet transmission, H-ARQ (Hybrid-Automatic Repeat Request) is proposed, for example, as described in Japanese Laid-Open Patent Publication No.2001-352315.

H-ARQ refers to a scheme obtained by combining ARQ and error correcting coding, and is directed to reducing the number of retransmissions and improving the throughput by improving the error rate of received signal using error correction. As a promising system for H-ARQ, two systems are proposed: the chase combining type scheme and the incremental redundancy type scheme.

It is a feature of the chase combining type H-ARQ (hereinafter referred to as "CC type H-ARQ") that a base station apparatus transmits the same packet as the last transmitted packet. Upon receiving the retransmitted packet, a mobile station apparatus combines the packets received until last time and the packet retransmitted this time, and performs error correcting decoding on the combined signal. Thus, in the CC type H-ARQ, the reception level is enhanced by combining the code words contained in the packets received until last time and the code words contained in the packet retransmitted this time, and so the error rate characteristic improves every time retransmission is repeated. In this way, errors are eliminated with a less number of retransmissions than in general ARQ, thereby improving the throughput.

Meanwhile, in the incremental redundancy type H-ARQ (hereinafter referred to as "IR type H-ARQ"), it is a feature that a base station apparatus retransmits a packet including a parity bit different from the parity bits contained in the packets transmitted until last time. A mobile station apparatus holds each received parity bit in a buffer, and, upon receiving a retransmittedpacket, performs error correcting decoding using both the parity bits contained in the packets received until last time and the parity bit contained in the packet received in retransmission. Thus, in the IR type, the parity bits for use in error correcting decoding are incremented in every retransmission, and so the error correcting capability is enhanced in the mobile station apparatus, and, as a result, the error rate characteristic improves every time retransmission is repeated. In this way, errors are eliminated with a less number of retransmissions than in general ARQ, thereby improving the throughput.

Furthermore, it is considered that using concatenated codes in H-ARQ enhances the error rate characteristic higher and improves the throughput. For example, by using turbo codes and Reed-Solomon codes as concatenated codes, it is possible to obtain both the advantage of resistance to white Gaussian noise (i.e. resistance to random errors) by turbo codes and the advantage of resistance to impulse like noise (i.e. resistance to burst errors) by Reed-Solomon codes, and it can be considered that the error rate characteristics is improved in various propagation environments.

As described above, it can be considered that using concatenated codes in H-ARQ surely improves the error rate characteristic in various propagation environments, but simply combining them only produces the sum effect of them.

For example, a case will be discussed below where concatenated codes comprised of turbo codes and Reed-Solomon codes are applied to the scheme called H-ARQ type 1. H-ARQ type 1 refers to the scheme of transmitting the same coded data in a retransmitted packet as data in a first packet.

More specifically, a transmission side performs error correcting coding processing on information bits, adds an error detecting code (for example, CRC bit), and transmits the result. The reception side performs error correcting decoding on a received packet and further performs error detection using the error detecting code. When an error is detected, the reception side discards the packet containing the error, and transmits a retransmission request to the transmission side as feedback. Based on the retransmission request, the transmission side encodes the packet with the same code and retransmits the packet. This series of processing is repeated until an error is not detected.

Meanwhile, even when retransmission is repeated, the possibility is strong that impulse like noise occurs at the same position in a packet. Therefore, although Reed-Solomon codes surely have resistance to the burst error, a symbol whose error cannot be corrected by Reed-Solomon codes at the first transmission time has a high probability of being erroneous at the retransmission time. In other words, in terms of the relationship between Reed-Solomon codes and retransmission, the effect of combining packets (chase combining) by retransmission is hardly obtained.

Such inconvenience becomes more notable in a frequency-hopping type OFDM system, for example. The frequency-hopping type OFDM system will now be described briefly. In the OFDM system applying frequency hopping, different hopping patterns are used among a plurality of cells, and interference among the cells is thereby averaged to perform communications.

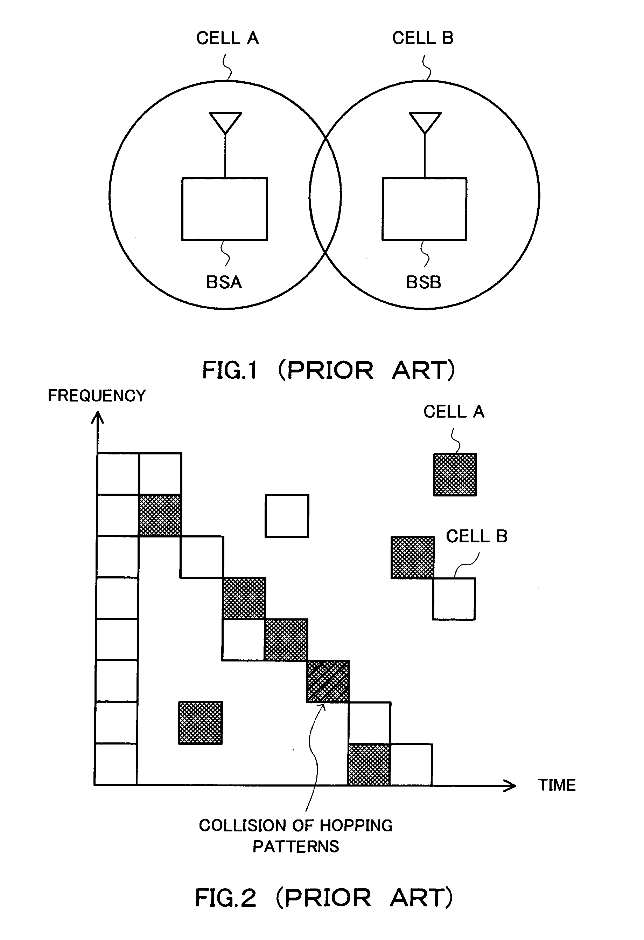

In other words, considering two adjacent cells A and B shown in FIG.1, base station BSA of cell A and base station BSB of cell B transmit OFDM signals of hopping patterns different from each other. Generally, since the hopping patterns are determined randomly in cells A and B, there is a possibility that the hopping patterns collide with each other by chance on some subcarrier at some point in time.

This will be describedbelowwith reference to FIG. 2. FIG.2 shows frequency-hopping OFDM signals transmitted from base station BSA of cell A and frequency hoppling OFDM signals transmitted from base station BSB of cell B. One unit of the vertical axis represents a subcarrier, and one unit of the horizontal axis represents one burst period. That is, one OFDM symbol is placed per square in the figure.

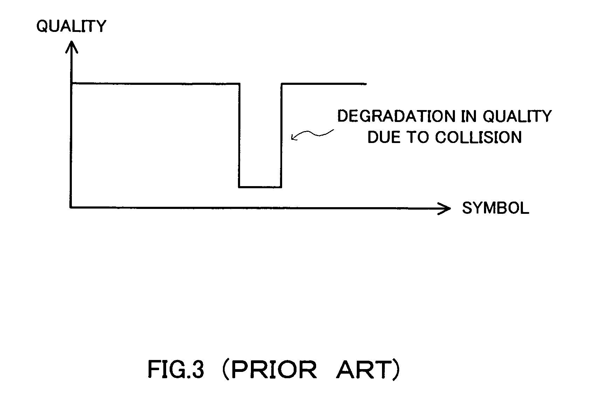

As can be seen from FIG.2, an OFDM signal of cell A collides with an OFDM signal of cell B accidentally on some subcarrier at some point in time. In the data symbol placed on the subcarrier at the collision, the reception quality degrades compared to other data symbols shown in FIG.3. Thus, in the OFDM system applying frequency hopping, since the quality deteriorates in a symbol suffering interference from another cell, it is necessary to perform error correcting processing upon decoding and correct the data of a symbol with degraded quality back to accurate decoded data.

Meanwhile, since such degradation due to the collision of symbols causes burst error, error correction for random errors such as turbo codes alone is not sufficient, and concatenated codes, for example, comprised of turbo codes and Reed-Solomon codes become significantly effective in improving error rate characteristic.

However, simply combining concatenated codes and H-ARQ in the frequency-hopping type OFDM system, as described above, would only produce the sum effect of the effect of concatenated codes and the effect of H-ARQ, and it is not possible to obtain adequate effects to improve the error rate characteristic.

### Disclosure of Invention

It is therefore an object of the present invention to provide a radio transmission apparatus, radio reception apparatus and radio transmission method capable of further enhancing the effect of improving the error rate characteristic by retransmission in the case of combining concatenated codes and retransmission technique.

This object is achieved by performing different outer coding processing on transmission data for each retransmission in concatenated coding the transmission data to transmit. In an Embodiment described below, it is proposed as a preferred example performing turbo coding processing conventionally used in H-ARQ as inner coding processing, while performing different Reed-Solomon coding processing for each retransmission as outer coding processing.

### Brief Description of Drawings

FIG.1 is a view illustrating adjacent cells;
FIG. 2 is a view to explain a collision of data symbols of frequency-hopping OFDM signals;
FIG.3 is a view illustrating degradation in quality of the data symbol due to the collision;
FIG.4 is a block diagram illustrating an example of a radio transmission apparatus to which the invention is applied;
FIG.5 is a block diagram illustrating an example of a radio reception apparatus to which the invention is applied;
FIG.6 is a block diagram illustrating a configuration of a coding section according to one Embodiment;
FIG.7(A) is a diagram illustrating a format of coded data output from a CRC adding section at the first transmission time;
FIG.7 (B) is a diagram illustrating a format of coded data output from an outer coding processing section at the first transmission time;
FIG.7 (C) is a diagram illustrating a format of coded data output from an inner coding processing section at the first transmission time;
FIG. 8 (A) is a diagram illustrating a format of coded data output from the CRC adding section at the first retransmission time;
FIG.8 (B) is a diagram illustrating a format of coded data output from the outer coding processing section at the first retransmission time;
FIG. 8 (C) is a diagram illustrating a format of coded data output from the inner coding processing section at the first retransmission time; and
FIG.9 is a block diagram illustrating a configuration of a decoding section of the Embodiment.

### Best Mode for Carrying Out the Invention

An Embodiment of the present invention will specifically be described below with reference to the accompanying drawings.

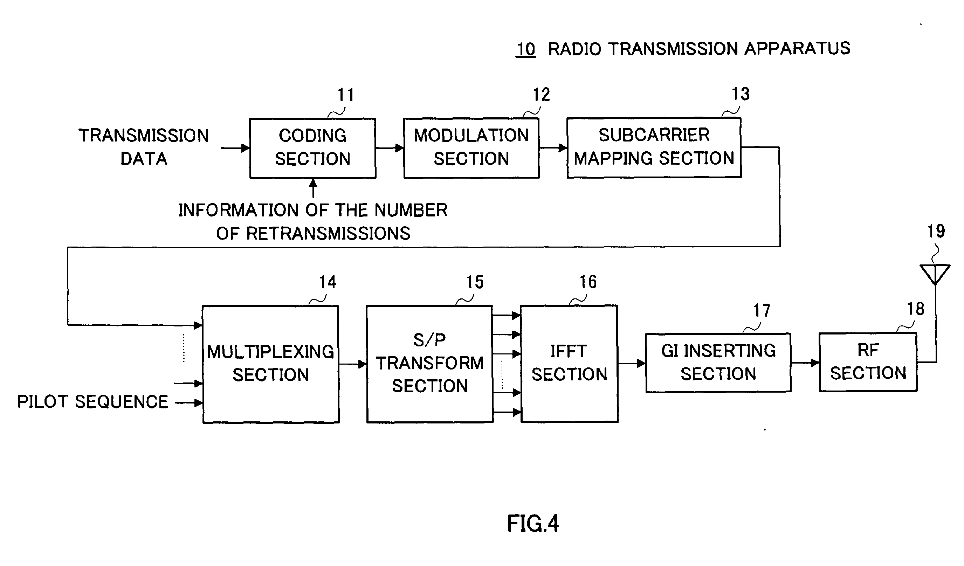

FIG.4 illustrates an overall configuration of a radio transmission apparatus according to the Embodiment of the invention. Radio transmission apparatus 10 is designed to transmit transmission signals by radio in the frequency-hopping OFDM system. Radio transmission apparatus 10 encodes transmission data in coding section 11. Coding section 11 receives as input information of the number of retransmissions from a control section not shown, and performs different coding processing depending on the number of retransmissions. The specific configuration of coding section 11 will be described later.

Modulation section 12 performs digital modulation processing such as QPSK (Quadrature Phase Shift Keying) and 16QAM (Quadrature Amplitude Modulation) on the coded data, and thereafter the result is sent to subcarrier mapping section 13.

Subcarrier mapping section 13 maps the modulated signal on a subcarrier of a predetermined hopping pattern. Multiplexing section 14 receives as input a pilot sequence and contorl data, in addition to mapped modulated signals for other users obtained in the same manner, multiplexes these, and sends the result to serial/parallel (S/P) transform section 15.

Subsequently, inverse fast Fourier transform (IFFT) section 16 performs inverse Fourier conversion on the signalsubjectedtoserial/parallelconversion,and guard interval (GI) inserting section 17 inserts a guard interval to the processed signal, and the result is sent to radio section (RF section) 18. RF section 18 performs processing such as digital/analog conversion, upconversion and amplification, on the input signal, and sends the processed signal to antenna 19. A frequency-hopping OFDM signal is thus transmitted from antenna 19.

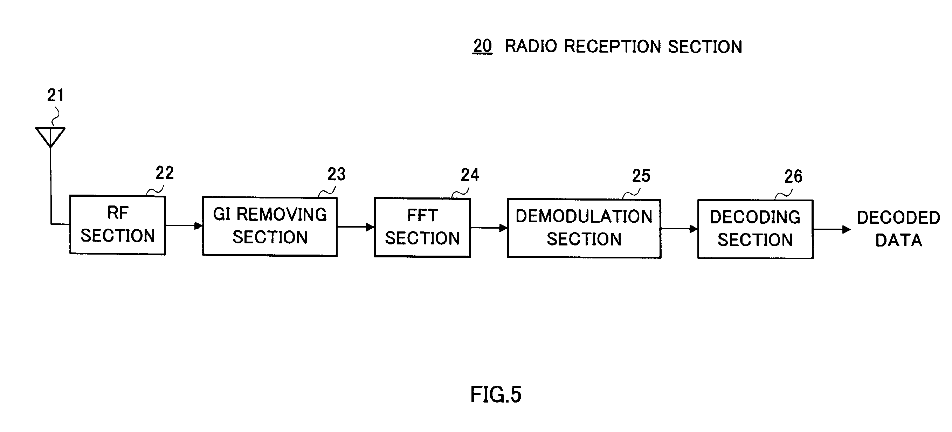

FIG.5 illustrates a configuration of radio reception apparatus 20 that receives a signal transmitted from radio transmission apparatus 10. In radio reception apparatus 20, radio section (RF section) 22 performs processing such as amplification, down-conversion, analog/digital conversion on the signal received in antenna 21, and the result is sent to guard interval removing section 23. Subsequently, fast Fourier transform (FFT) section 24 performs Fourier transform processing on the signal from which the guard interval is removed, and the result is sent to demodulation section 25.

Demodulation section 25 performs demodulation processing corresponding to modulation section 12 of radio transmission apparatus 10, and outputs the demodulated signal to decoding section 26. Decoding section 26 also performs decoding processing corresponding to coding section 11 of radio transmission apparatus 10 and thus obtains received data.

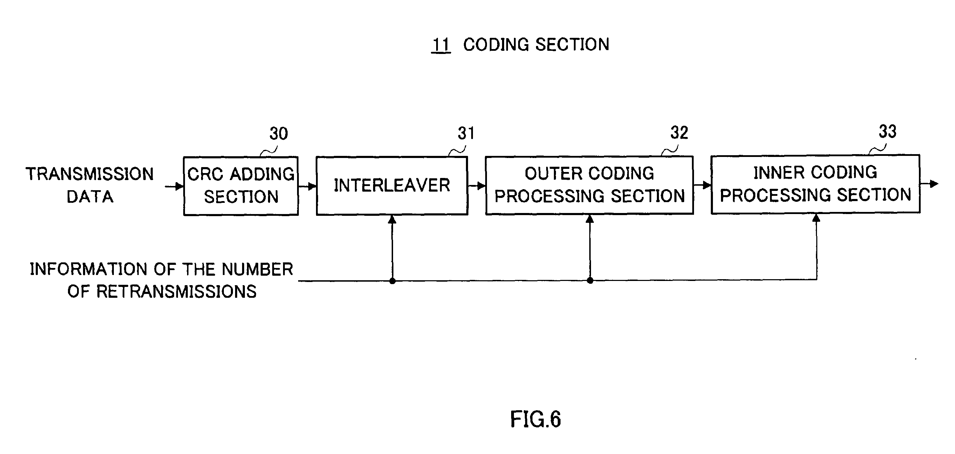

FIG.6 illustrates a configuration of coding section 11. Coding section 11 has outer coding processing section 32 and inner coding processing section 33, and performs concatenated coding processing on transmission data. In coding section 11, transmission data is first input to CRC (Cyclic Redundancy Check) adding section 30, and CRC adding section 30 adds a CRC code for error detection. The transmission data with CRC added thereto is sent to interleaver 31. Interleaver 31 has information of the number of retransmissions input thereto, and performs interleaving using different interleaving patterns depending on the number of retransmissions. The interleaved data is sent to outer coding processing section 32.

In this Embodiment, outer coding processing section 32 is comprised of a Reed-Solomon coder, and performs Reed-Solomon coding processing on transmission data. Inner coding processing section 33 is comprised of a turbo coder, and performs turbo coding processing on coded data subjected to the Reed-Solomon coding processing. The turbo-coded data is sent to modulation section 12 in FIG. 4.

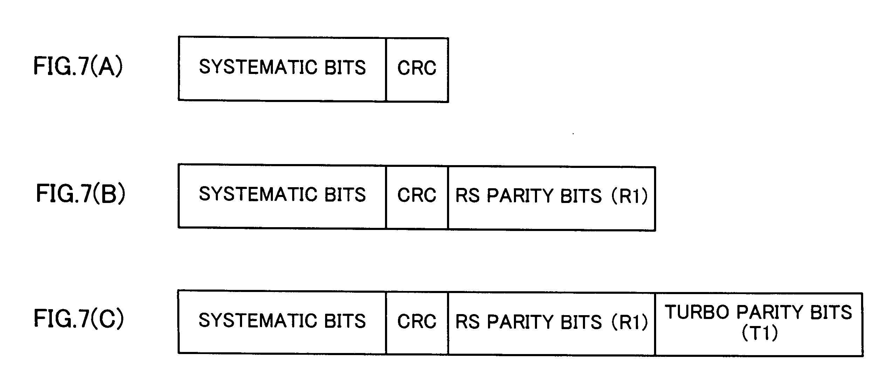

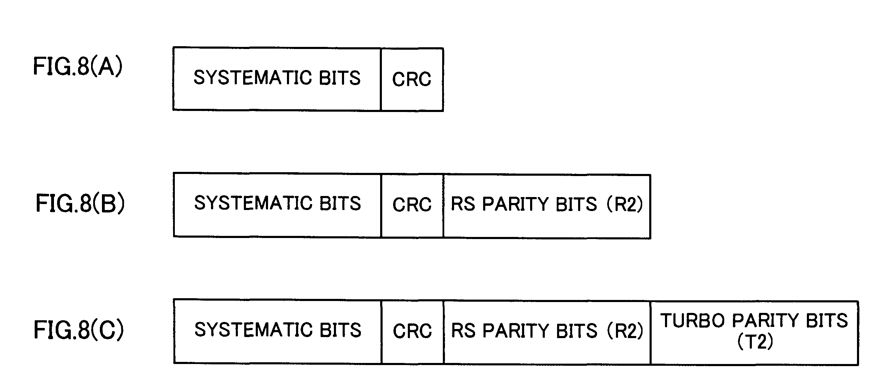

FIGs.7(A) to 7(C) and FIGs.8(A) to 8 (C) illustrate formats of coded data obtained in coding section 11. Herein, FIGs.7 (A) to 7 (C) illustrate the formats of coded data upon the first transmission, and FIGs.8(A) to 8(C) illustrate the frame formats of coded data upon the first retransmission. FIGs.7(A) and 8(A) illustrate the output of CRC adding section 30, where CRC is added to the systematic bits both upon the first transmission time and upon the first retransmission.

FIGs.7(B) and 8(B) illustrate the output of outer coding processing section 32, where Reed-Solomon parity bits (RS parity bits) are added. Outer coding processing section 32 performs the Reed-Solomon coding processing on systematic bits in different order for each retransmission determined by interleaver 31, and, therefore, RS parity bits R1 in FIG.7(B) and RS parity bits R2 in FIG.8(B) are different. By this means, the reception side is capable of performing error correcting processing due to Reed-Solomon decoding using RS parity bits different between the last transmission and current transmission, thereby reducing the probability that received data is successively erroneous.

FIGs.7(C) and 8(C) illustrate the output of inner coding processing section 33, where turbo parity bits T1 or T2 are added that are different between the last transmission and current retransmission. In this Embodiment, turbo parity bits different between the last transmission and current transmission are transmitted, but the same turbo parity bits may be transmitted.

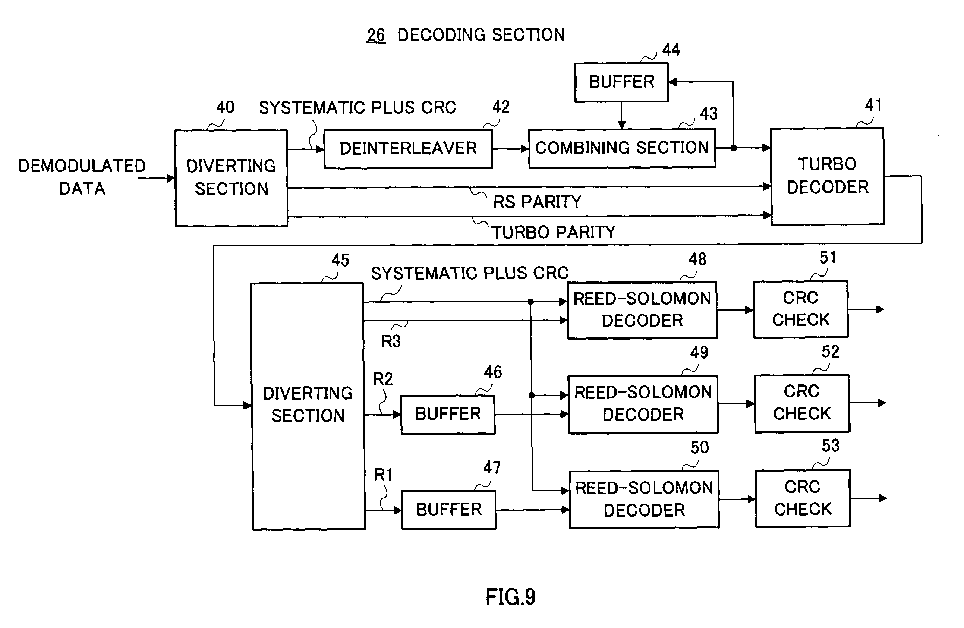

FIG.9 illustrates a configuration of decoding section 26 of FIG.5. In decoding section 26, diverting section 40 diverts the demodulated data from demodulation section 25 to systematic bits plus CRC bits (i.e. portion of FIG. 7 (A) or 8(A)), Reed-Solomon parity bits and turbo parity bits. Among them, the Reed-Solomon parity bits and turbo parity bits are output to turbo decoder 41.

Meanwhile, the systematic bits and CRC bits are sent to deinterleaver 42. Deinterleaver 42 performs inverse processing to that in interleaver 31 of FIG. 6, and thereby restores the systematic bits and CRC bits rearranged in a different order for each retransmission to the original order. The output of deinterleaver 42 is sent to combining section 43. Combining section 43 combines the systematic bits and CRC bits that are transmitted until last time and stored in buffer 44, and the systematic bits and CRC bits transmitted this time. It is thus possible to obtain combined gain of the systematic bits and CRC bits with increases in retransmission.

Turbo decoder 41 turbo-decodes the combined systematic bits, CRC bits and Reed-Solomon parity bits using turbo parity bits. By this means, even when random errors occur on the systematic bits, CRC bits and Reed-Solomon bits, the errors can be corrected properly. The output of turbo decoder 41 is sent to diverting section 45.

Diverting section 45 diverts the turbo-decoded data to: systematic bits plus CRC bits, andReed-Solomonparity bits. At this point, the Reed-Solomon parity bits are varied for each retransmission as described above, and are therefore stored in buffers 46 and 47 depending on the number of retransmissions. In other words, Reed-Solomon parity bits R1 of the first transmission are stored in buffer 47, Reed-Solomon parity bits R2 of the first retransmission are stored in buffer 46, and Reed-Solomon parity bits R3 of the second retransmission (retransmitted this time) are directly sent to Reed-Solomon decoder 48.

The systematic bits and CRC bits are sent to all Reed-Solomon decoders 48 to 50. Reed-Solomon decoder 48 performs Reed-Solomon decoding on the systematic bits and CRC bits using Reed-Solomon parity bits R3 retransmitted this time (i.e. transmitted in second retransmission). Reed-Solomon decoder 49 performs Reed-Solomon decoding on the systematic bits and CRC bits using Reed-Solomon parity bits R2 of the first retransmission. Reed-Solomon decoder 50 performs Reed-Solomon decoding on the systematic bits and CRC bits using Reed-Solomon parity bits R1 of the first transmission. Each of CRC check sections 51 to 53 checks whether an error is present on respective Reed-Solomon decoding processed data, and thereafter outputs the data as received data.

In this way, decoding section 26 performs Reed-Solomon decoding processing using different Reed-Solomon parity bits R1, R2 and R3 transmitted every retransmission and is therefore capable of obtaining diversity effect corresponding to the number of retransmissions, and the possibility of obtaining decoded data without burst errors increases.

The operation of radio transmission apparatus 10 and radio reception apparatus 20 of this Embodiment will be described below. Radio transmission apparatus 10 transmits a transmission signal subjected to coding processing and modulation processing as a frequency-hopping OFDM signal. Therefore, the frequency-hopping OFDM signal transmitted from radio transmission apparatus 10 has a risk of colliding accidentally with a frequency-hopping OFDM signal transmitted from another radio transmission apparatus on some subcarrier. When such a collision occurs, a symbol multiplexed on the subcarrier degrades, and a burst error tends to occur on received data.

Radio transmission apparatus 10 performs different Reed-Solomon coding processing for each retransmission on transmission data, and transmits different Reed-Solomon parity bits for each retransmission. Therefore, even when a burst error occurs on parity bits and/or CRC bits, such a possibility increases that the burst error can be corrected using Reed-Solomon parity bits at either retransmission time.

Further, since radio transmission apparatus 10 performs turbo coding as inner coding processing, even when a random error occurs on systematic bits, CRC bits and/or Reed-Solomon parity bits, the random error can be corrected by the combining gain due to retransmission in turbo decoding.

Thus, according to the above-mentioned configuration, outer coding processing section 32 performs error correcting coding resistant to the burst error, while inner coding processing section 33 performs error correcting coding resistant to the random error, whereby the error resistance is enhanced to the burst error and random error as the number of retransmissions increases, and it is possible to suppress degradation in error rate characteristic and increases in the number of retransmissions. In addition, the processing in outer coding processing section 32 is varied corresponding to the number of retransmissions, and the decoding side is thereby capable of performing outer code decoding processing using different outer code parity bits R1, R2 and R3 corresponding to the number of retransmissions, and thus improves the capability of correcting the burst error. As a result, in the case of combining concatenated codes and retransmission technique, it is possible to implement the radio transmission apparatus and radio reception apparatus capable of further enhancing the effect of improving the error rate characteristic due to retransmission.

The case is described in the aforementioned Embodiment where the present invention is applied to radio transmission apparatus 10 and radio reception apparatus 20 in the frequency-hoppling OFDM system, but the invention is not limited to such a case and is applicable widely to radio transmission apparatuses and radio reception apparatuses aimed at improving the quality of received data due to retransmission.

Further, the case is described in the above-mentioned Embodiment where a Reed-Solomon coder is used as outer coding processing section 32, but outer coding processing section 32 of the invention is not limited thereto, may be a BCH coder, for example, and only needs to be a coder capable of performing error correcting coding processing resistant to the burst error. In other words, it is required to vary the processing in an outer coder resistant to the burst error for each retransmission corresponding to the number of retransmission.

Furthermore, interleaver 31 is provided to perform different outer coding processing corresponding to the number of retransmissions in the above-mentioned Embodiment, but the invention is not limited thereto. For example, a plurality of outer coders may be provided which performs respective different coding processing, and selected to perform outer coding processing corresponding to the number of retransmissions.

Still furthermore, the case is described in the above-mentioned Embodiment where a turbo coder is used as inner coding processing section 33, but the inner coding processing section of the invention is not limited thereto, and only needs to be a coder capable of performing error correction resistant to the random error, and a convolutional coder may be used other than the turbo coder.

The present invention is not limited to the above-mentioned Embodiment, and is capable of being carried into practice with various modifications thereof .

An aspect of a radio transmission apparatus of the invention adopts a configuration provided with an outer coding section that performs different coding processing on transmission data corresponding to the number of retransmissions, an inner coding section that performs inner coding processing on coded data subjected to outer coding processing, and a transmitter that transmits a radio signal of the coded data subjected to the inner coding processing.

According to this configuration, for example, the outer coding section performs error correcting coding resistant to the burst error, while the inner coding section performs error correcting coding resistant to the random error, whereby the resistance is enhanced to the burst error and random error as the number of retransmissions increases, and it is possible to suppress degradation in error rate characteristic and increases in the number of retransmissions. In particular, since the processing in the outer coding section is varied corresponding to the number of retransmissions, the decoding side is capable of performing outer code decoding processing using a plurality of different outer code parity bits, and thus improves the capability of correcting the burst error.

Another aspect of the radio transmission apparatus of the invention adopts a configuration where the outer coding section has an interleaver that performs interleaving on transmission data with a different interleaving pattern corresponding to the number of retransmissions, and a Reed-Solomon coder that performs Reed-Solomon coding processing on the interleaving-processed transmission data, and the inner coding section has a turbo coder.

According to this configuration, a Reed-Solomon coder is used as the outer coding section whereby it is possible to perform error correcting coding processing resistant to the burst error, while a turbo coder is used as the inner coding section whereby it is possible to perform error correcting coding processing resistant to the random error. Further, the decoding side is capable of obtaining the combining gain due to retransmission by H-ARQ on the turbo-coded data, and further obtaining the diversity effect due to retransmission by performing Reed-Solomon decoding processing on the turbo-decoded data using different Reed-Solomon parity bits for each retransmission. In other words, the error rate characteristic can be improved on the random error by the combining gain due to retransmission, while being improved on the burst error by the diversity effect due to retransmission. As a result, it is possible to improve both the random error characteristic and burst error characteristic.

Another aspect of the radio transmission apparatus of the invention adopts a configuration where the transmitter performs frequency-hopping OFDM processing on the coded data, and transmits the radio signal.

According to this configuration, although a frequency-hopping OFDM signal has a possibility that subcarriers collide with each another between adjacent radio transmission apparatuses, where the quality of symbols multiplexed on the subcarriers deteriorates and burst errors tend to occur on transmission data, by the outer coding section performing different outer coding processing for each retransmission, it is possible to enhance the probability of eliminating errors on the decoded data due to the diversity effect.

An aspect of a radio reception apparatus of the invention is a radio reception apparatus that receives signals which are obtained by performing different outer coding processing on transmission data for each retransmission and transmitted, and adopts a configuration provided with a combiner that combines information bits corresponding to the number of retransmissions subjected to inner coding processing, an inner code decoding section that inner-code decodes the information bits combined in the combiner and an outer code parity bit, and an outer code decoding section that decodes the information bits obtained in the inner code decoding section using different outer code parity bits corresponding to the number of retransmissions.

According to this configuration, since the combining gain due to retransmission is obtained on the information bits input to the inner code decoding section, the error rate characteristics is improved on the decoded data output from the inner code decoding section as the number of retransmissions increases. Further, the outer code decoding section decodes the information bits using different outer code parity bits corresponding to the number of retransmissions, is thereby capable of obtaining the diversity effect corresponding to the number of retransmissions, and improves the error rate characteristic as the number of retransmissions increases. As a result, it is possible to obtain decoded data with less random errors due to inner code decoding and with less burst errors due to outer code decoding.

As described above, according to the invention, in the case of combining concatenated codes and retransmission technique, by performing different outer coding processing on transmission data for each retransmission, it is possible to acquire both the combining gain due to the inner coding processing and the diversity effect due to the outer code by retransmission, and it is thus possible to implement the radio transmission apparatus and radio reception apparatus capable of effectively reducing both the random error and burst error while taking full advantage of retransmission.

This application is based on Japanese Patent Application No. 2003-91749 filed on March 28, 2003, entire content of which is expressly incorporated by reference herein.

### Industrial Applicability

The present invention is suitable for use in, for example, a portable information terminal, base station thereof and the like.

## Claims

1. A radio transmission apparatus comprising:
an outer coding section that performs different coding processing on transmission data depending on the number of retransmissions;
an inner coding section that performs inner coding processing on coded data subjected to outer coding processing; and
a transmitter that transmits by radio the coded data subjected to the inner coding processing.

2. The radio transmission apparatus according to claim 1, wherein:
the outer coding section has:
an interleaver that performs interleaving on transmission data using different interleaving patterns depending on the number of retransmissions; and
a Reed-Solomon coder that performs Reed-Solomon coding processing on the interleaving-processed transmission data; and
the inner coding section has a turbo coder.

3. The radio transmission apparatus according to claim 1, wherein the transmitter performs frequency-hopping OFDM processing on the coded data, and transmits said data by radio.

4. A radio reception apparatus that receives and decodes signals which are obtained by performing different outer coding processing on transmission data for each retransmission and transmitted, said reception apparauts comprising:
a combiner that combines information bits corresponding to the number of retransmissions subjected to inner coding processing;
an inner code decoding section that inner-code decodes the information bits combined in the combiner and an outer code parity bit; and
an outer code decoding section that decodes the information bits obtained in the inner code decoding section using different outer code parity bits corresponding to the number of retransmissions.

5. A Radio transmission method for performing concatenated coding processing on transmission data and transmitting said data by radio, said method comprising performing different outer coding processing on the transmission data for each retransmission.

6. The radio transmission method according to claim 5, wherein the outer coding processing comprises Reed-Solomon coding processing and inner code processing comprises turbo coding processing.
